# EUROPEAN PATENT SPECIFICATION

(11) **EP 4 084 094 B1**
(45) Date of publication and mention of the grant of the patent: **22.11.2023**
(21) Application number: 22150446.7
(22) Date of filing: 06.01.2022
(51) Int. Cl.: H01L 33/00

(54) **MULTI-USE TRANSFER MOLD AND METHOD OF MANUFACTURING DISPLAY APPARATUS**
MEHRZWECK-TRANSFERFORM UND VERFAHREN ZUR HERSTELLUNG EINER ANZEIGEVORRICHTUNG
MOULE DE TRANSFERT À USAGES MULTIPLES ET PROCÉDÉ DE FABRICATION D'UN DISPOSITIF D'AFFICHAGE

(30) Priority: 27.04.2021 US 202163180295 P; 24.06.2021 KR 20210082328
(43) Date of publication of application: 02.11.2022
(73) Proprietor: Samsung Electronics Co., Ltd., Gyeonggi-do 16677 (KR)
(72) Inventor: HWANG, Junsik, Suwon-si, 16678 (KR); HWANG, Kyungwook, Suwon-si, 16678 (KR); KIM, Dongho, Suwon-si, 16678 (KR); KIM, Hyunjoon, Suwon-si, 16678 (KR); PARK, Joonyong, Suwon-si, 16678 (KR); HONG, Seogwoo, Suwon-si, 16678 (KR)
(74) Representative: Elkington and Fife LLP

(56) References cited:
- EP-A1- 3 128 543
- EP-A1- 3 742 477
- CN-A- 111 146 129
- US-A1- 2017 154 919
- US-A1- 2019 318 951
- US-A1- 2020 043 760
- US-A1- 2021 082 734

## Description

### FIELD OF THE INVENTION

The present disclosure relates to a multi-use transfer mold used to transfer a micro-light-emitting device onto a driving substrate and a method of manufacturing a display apparatus, the method using the multi-use transfer mold.

### BACKGROUND OF THE INVENTION

As display apparatuses, a liquid crystal display, an organic light-emitting diode (OLED) display, etc. have been widely used. Recently, techniques for manufacturing a high-resolution display apparatus by using micro-light-emitting devices have been highlighted.

For a display apparatus using a micro-light-emitting device, various techniques, for example, a technique of transferring a micro-sized light-emitting diode onto a desired pixel location of a display apparatus, a repair method, a method of realizing a desired color etc. are required.

US 2019/318951 A1, US2017/154919 A1, US 2020/043760 A1 and CN 111146129 A disclose a method of manufacturing a display apparatus by using a multi-use transfer mold.

### SUMMARY OF THE INVENTION

Provided is a multi-use transfer mold to be used a plurality of times for transferring micro-light-emitting devices onto a driving substrate.

Also provided is a method of manufacturing a display apparatus, the method including transferring a micro-light-emitting device by using a multi-use transfer mold.

Additional aspects will be set forth in part in the description which follows and, in part, will be apparent from the description, or may be learned by practice of embodiments of the disclosure.

According to an aspect of an example embodiment, there is provided a multi-use transfer mold including: a transfer substrate including a plurality of pixels, and a first groove and a second groove provided in each of the plurality of pixels, wherein the first groove includes a first transfer area configured to accommodate a transfer micro-light-emitting device, and a first preliminary area connected to the first transfer area and configured to accommodate a preliminary micro-light-emitting device, wherein the first preliminary area includes a first outlet configured to allow the preliminary micro-light-emitting device to move to the first transfer area, wherein the second groove includes a second transfer area configured to accommodate the transfer micro-light-emitting device, and a second preliminary area connected to the second transfer area and configured to accommodate the preliminary micro-light-emitting device, and wherein the second preliminary area includes a second outlet configured to allow the preliminary micro-light-emitting device to move to the second transfer area.

The first transfer area and the second transfer area may be spaced apart from each other.

At least a portion of the first preliminary area and at least a portion of the second preliminary area may be integral with each other.

A portion of the first preliminary area, that is adjacent to the first transfer area, may have a tapered structure having a width decreasing toward the first transfer area, and a portion of the second preliminary area, that is adjacent to the second transfer area, may have a tapered structure having a width decreasing toward the second transfer area.

A portion of the first preliminary area, that is adjacent to the first transfer area, may have a straight-shaped structure having a width that is the same as a width of the first transfer area, and a portion of the second preliminary area, that is adjacent to the second transfer area, may have a straight-shaped structure having a width that is the same as a width of the second transfer area.

A first portion of the first preliminary area, that is adjacent to the first transfer area, may have a straight-shaped structure having a width that is the same as a width of the first transfer area, a second portion of the first preliminary area, that is adjacent to the first portion of the first preliminary area, may have a tapered structure having a width decreasing toward the first portion of the first preliminary area, a first portion of the second preliminary area, that is adjacent to the second transfer area, may have a straight-shaped structure having a width that is the same as a width of the second transfer area, and a second portion of the second preliminary area, that is adjacent to the first portion of the second preliminary area, may have a tapered structure having a width decreasing toward the first portion of the second preliminary area.

Each of the first transfer area and the second transfer area may have a width that is greater than a width of the transfer micro-light-emitting device and less than twice the width of the transfer micro-light-emitting device.

Each of the plurality of pixels may include a plurality of sub-pixels, and each of the first transfer area and the second transfer area may have a size corresponding to a number of transfer micro-light-emitting devices included in each of the plurality of sub-pixels.

The first preliminary area may have a width that is equal to or greater than a width of the first transfer area, and the second preliminary area may have a width that is equal to or greater than a width of the second transfer area.

According to an aspect of an example embodiment, there is provided a method of manufacturing a display apparatus, the method including: preparing a transfer substrate of a multi-use transfer mold including a plurality of pixels, each of the plurality of pixels including a first groove and a second groove, wherein the first and second grooves include a first and second transfer area and a first and second preliminary area respectively, wherein the first and second preliminary areas comprise first and second outlets respectively configured to allow a preliminary micro-light-emitting device to move to the first and second transfer areas respectively; supplying preliminary micro-light-emitting devices and transfer micro-light-emitting devices to each of the first and second grooves of each of the plurality of pixels; aligning the transfer micro-light-emitting devices on the transfer areas and aligning a preliminary micro-light-emitting devices on the preliminary areas; bonding-transferring the transfer micro-light-emitting devices to a pixel of a first driving substrate, the pixel of the first driving substrate corresponding to the transfer micro-light-emitting devices; moving the preliminary micro-light-emitting devices to the transfer areas, which is empty after the transfer micro-light-emitting devices are bond-transferred to the pixel of the first driving substrate; and bonding-transferring the preliminary micro-light-emitting devices moved to the transfer areas to a pixel of a second driving substrate, the pixel of the second driving substrate corresponding to the preliminary micro-light-emitting devices.

Each of the plurality of pixels may include a plurality of sub-pixels, the first groove and the second groove being included in respective sub-pixels of the plurality of sub-pixels, the first transfer area of the first groove may be configured to accommodate the transfer micro-light-emitting device, and the first preliminary area connected to the first transfer area and configured to accommodate the preliminary micro-light-emitting device, , the second transfer area of the second groove may be configured to accommodate the transfer micro-light-emitting device, and the second preliminary area connected to the second transfer area and configured to accommodate the preliminary micro-light-emitting device.

The first transfer area and the second transfer area may be spaced apart from each other.

At least a portion of the first preliminary area and at least a portion of the second preliminary area may be integral with each other.

A portion of the first preliminary area, that is adjacent to the first transfer area, may have a tapered structure having a decreasing width toward the first transfer area.

A portion of the first preliminary area, that is adjacent to the first transfer area, may have a straight-shaped structure having a width that is the same as a width of the first transfer area.

A first portion of the first preliminary area, that is adjacent to the first transfer area, may have a straight-shaped structure having a width that is the same as a width of the first transfer area, and
a second portion of the first preliminary area, that is adjacent to the portion of the first preliminary area, may have a tapered structure having a width decreasing toward the first portion of the first preliminary area.

The first transfer area may have a width that is greater than a width of the transfer micro-light-emitting device and less than twice the width of the transfer micro-light-emitting device.

Each of the plurality of pixels may include a plurality of sub-pixels, and the first transfer area may have a size corresponding to a number of transfer micro-light-emitting devices included in each of the plurality of sub-pixels.

### BRIEF DESCRIPTION OF THE DRAWINGS

The above and other aspects, features, and advantages of certain example embodiments of the disclosure will be more apparent from the following description taken in conjunction with the accompanying drawings, in which:
FIG. 1 schematically illustrates a multi-use transfer mold according to an example embodiment;
FIG. 2 illustrates a multi-use transfer mold according to another example embodiment;
FIG. 3 illustrates an enlarged pixel structure of the multi-use transfer mold illustrated in FIG. 2;
FIG. 4 illustrates a multi-use transfer mold according to another example embodiment;
FIG. 5 illustrates a multi-use transfer mold according to another example embodiment;
FIG. 6 illustrates a multi-use transfer mold according to another example embodiment;
FIGS. 7 through 10 illustrate modified examples of the multi-use transfer mold illustrated in FIG. 6;
FIGS. 11 through 17 are diagrams for describing a method of manufacturing a display apparatus, the method using a multi-use transfer mold, according to an example embodiment;
FIG. 18 is a schematic block diagram of an electronic device according to an example embodiment;
FIG. 19 illustrates an example in which a display apparatus, according to an example embodiment, is applied to a mobile device;
FIG. 20 illustrates an example in which a display apparatus, according to an embodiment, is applied to a vehicle display apparatus;
FIG. 21 illustrates an example in which a display apparatus, according to an example embodiment, is applied to augmented reality (AR) glasses;
FIG. 22 illustrates an example in which a display apparatus, according to an example embodiment, is applied to a signage; and
FIG. 23 illustrates an example in which a display apparatus, according to an example embodiment, is applied to a wearable display.

### DETAILED DESCRIPTION

Reference will now be made in detail to embodiments, examples of which are illustrated in the accompanying drawings, wherein like reference numerals refer to like elements throughout. In this regard, embodiments may have different forms and should not be construed as being limited to the descriptions set forth herein. Accordingly, embodiments are merely described below, by referring to the figures, to explain aspects. As used herein, the term "and/or" includes any and all combinations of one or more of the associated listed items. Expressions such as "at least one of," when preceding a list of elements, modify the entire list of elements and do not modify the individual elements of the list.

Hereinafter, a multi-use transfer mold and a method of manufacturing a display apparatus according to various embodiments will be described in detail with reference to the accompanying drawings. In the drawings, the same reference numerals denote the same elements and sizes of elements may be exaggerated for clarity and convenience of explanation. Although the terms first, second, etc. may be used herein to describe various elements, these terms do not limit the components. These terms are only used to distinguish one element from another.

As used herein, the singular terms "a" and "an" are intended to include the plural forms as well, unless the context clearly indicates otherwise. It will be further understood that when a part "includes" or "comprises" an element, unless otherwise defined, the part may further include other elements, not excluding the other elements. A size of each element in the drawings may be exaggerated for clarity and convenience of explanation. Also, when a certain material layer is described as being on a substrate or another layer, the material layer may be on the substrate or the other layer by directly contacting the same, or a third layer may be arranged between the material layer, and the substrate or the other layer. Also, a material included in each of layers in embodiments to be described below is only an example and other materials may also be used.

Also, the terms such as "... unit," "module," or the like used in the specification indicate a unit, which processes at least one function or motion, and the unit may be implemented by hardware or software, or by a combination of hardware and software.

Particular executions described in the embodiments are examples and do not limit the technical scope by any means. For the sake of brevity, conventional electronics, control systems, software development and other functional aspects of the systems may not be described. Furthermore, the connecting lines, or connectors shown in the various figures presented are intended to represent example functional relationships and/or physical or logical couplings between the various elements. It should be noted that many alternative or additional functional relationships, physical connections or logical connections may be present in a practical device.

The term "the" and other equivalent determiners may correspond to a singular referent or a plural referent.

Unless orders of operations included in a method are specifically described or there are contrary descriptions, the operations may be performed according to appropriate orders. The use of all example terms (e.g., etc.) are merely for describing the disclosure in detail and the disclosure is not limited to the examples and the example terms.

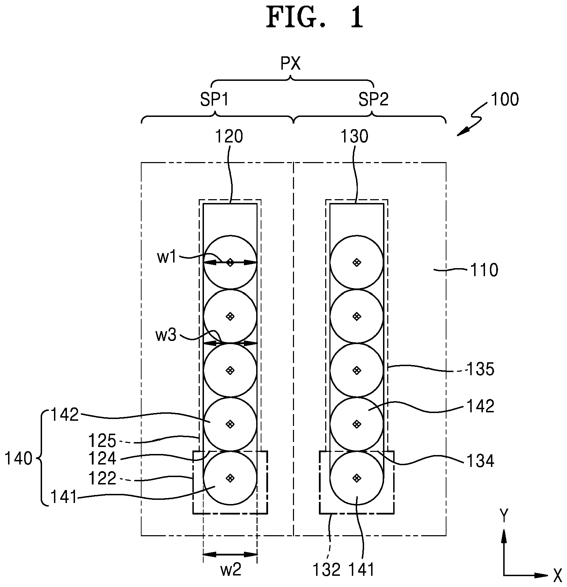

FIG. 1 is a plan view of a multi-use transfer mold according to an example embodiment.

The multi-use transfer mold 100 may include a plurality of pixels PX, and each pixel PX may include a plurality of sub-pixels. FIG. 1 illustrates one pixel PX. The plurality of sub-pixels may include, for example, a first sub-pixel SP1 and a second sub-pixel SP2.

The multi-use transfer mold 100 may include a transfer substrate 110, a first groove 120 and a second groove 130 provided in the transfer substrate 110. Each of the first groove 120 and the second groove 130 may include an area for accommodating a micro-light-emitting device 140. The micro-light-emitting device 140 may include a transfer micro-light-emitting device 141 to be transferred onto a driving substrate of a display apparatus to be described below and a preliminary micro-light-emitting device 142 waiting to be transferred onto the driving substrate.

The first groove 120 includes a first transfer area 122 (e.g., an end portion) for accommodating the transfer micro-light-emitting device 141 and a first preliminary area 125 connected to the first transfer area 122 and provided for accommodating the preliminary micro-light-emitting device 142. The first preliminary area 125 may have an outlet 124 (e.g., a first outlet) configured such that the preliminary micro-light-emitting device 142 may pass into the first transfer area 122 through the outlet 124. The first transfer area 122 may have a size for accommodating at least one transfer micro-light-emitting device 141, and FIG. 1 illustrates an example in which the first transfer area 122 has a size for accommodating one transfer micro-light-emitting device 141.

The first transfer area 122 may have a width w2 that is greater than or equal to a width w1 of the transfer micro-light-emitting device 141 and less than twice the width w1 of the transfer micro-light-emitting device 141, in order to accommodate one transfer micro-light-emitting device 141. The width w1 of the transfer micro-light-emitting device 141 may indicate a maximum cross-sectional width of the transfer micro-light-emitting device 141. FIG. 1 illustrates an example in which the transfer micro-light-emitting device 141 has a circular cross-section, and in this case, the width w1 may indicate a diameter of the circular cross-section. A width w3 of the first preliminary area 125 may be equal to or greater than the width w2 of the first transfer area 122. The width w2 of the first transfer area 122 and the width w3 of the first preliminary area 125 may be in a direction (e.g., an X direction in FIG. 1) perpendicular to a direction (a Y direction) from the first transfer area 122 to the first preliminary area 125. The width w3 of the first preliminary area 125 may not be constant according to a shape of the first preliminary area 125. So long as a portion of the first preliminary area 125, at which the first transfer area 122 and the first preliminary area 125 meet each other, that is, the outlet 124, has a size allowing the preliminary micro-light-emitting device 142 to pass through, a size and a shape of the first preliminary area 125 are not limited. For example, the first preliminary area 125 may have a straight groove shape having a constant width, so that the preliminary micro-light-emitting devices 142 may be serially arranged.

The first transfer area 122 may be provided at an end of the first groove 120. Although it is to be described below, it may be mentioned that because the preliminary micro-light-emitting device 142 may be pushed to the first transfer area 122, it is desirable that the first transfer area 122 be provided at an end of the first groove 120.

The second groove 130 may include a second transfer area 132 for accommodating the transfer micro-light-emitting device 141 and a second preliminary area 135 connected to the second transfer area 132. The second preliminary area 135 may have an outlet 134 (e.g., a second outlet) configured to allow the preliminary micro-light-emitting device 142 to pass into the second transfer area 132. The second transfer area 132 and the second preliminary area 135 may have substantially the same configurations as those of the first transfer area 122 and the first preliminary area 125 described above, and thus, detailed descriptions of the second transfer area 132 and the second preliminary area 135 are omitted.

A method of using the multi-use transfer mold 100 is described below. The micro-light-emitting device 140 may be transferred to the first groove 120 and the second groove 130. As a transferring method, a pick and place method, a stamping method, a fluid self-assembly method, etc. may be used. Through the transferring, transfer micro-light-emitting devices 141 may be arranged in the first transfer area 122 and the second transfer area 132, and preliminary micro-light-emitting devices 142 may be arranged in the first preliminary area 125 and the second preliminary area 135. When the transfer micro-light-emitting devices 141 arranged in the first transfer area 122 and the second transfer area 132 are transferred onto a driving substrate to be described below, the first transfer area 122 and the second transfer area 132 may become empty. The preliminary micro-light-emitting devices 142 may be moved to the first transfer area 122 and the second transfer area 132 that have become empty, and then, the preliminary micro-light-emitting devices 142 may be transferred onto another driving substrate. By using this method repeatedly, until exhaustion of the preliminary micro-light-emitting devices 142, the micro-light-emitting devices 140 may be transferred onto different driving substrates a plurality of times.

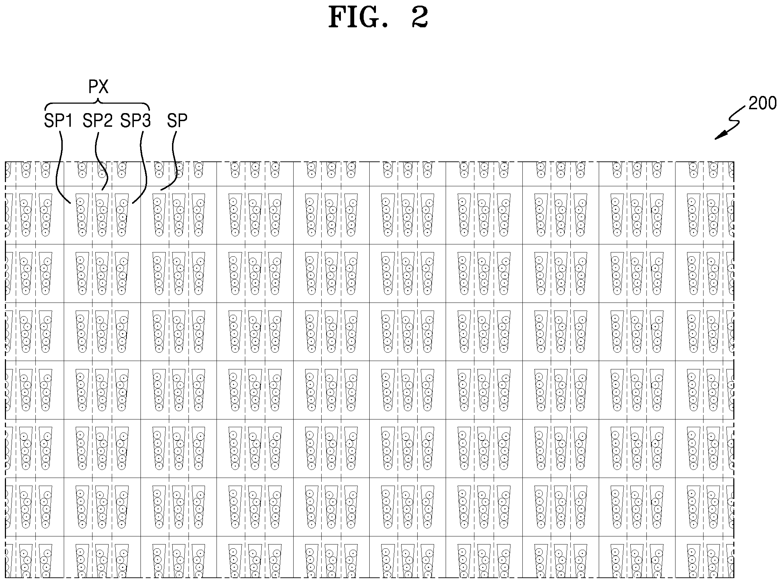

FIG. 2 is a plan view of a multi-use transfer mold 200 according to another example embodiment.

The multi-use transfer mold 200 may include a plurality of pixels PX, and each of the plurality of pixels PX may include a plurality of sub-pixel areas SP. A pixel PX may indicate a unit, in which components are repeatedly arranged, or may be a unit for displaying an image. Although it is not necessary for an image to be displayed on the multi-use transfer mold 200, the pixel PX and the sub-pixel SP of the multi-use transfer mold 200 are to be used herein as concepts corresponding to a pixel and a sub-pixel of a display apparatus that is manufactured by using the multi-use transfer mold 200. For example, each of the plurality of pixels PX may include a first sub-pixel SP1, a second sub-pixel SP2, and a third sub-pixel SP3.

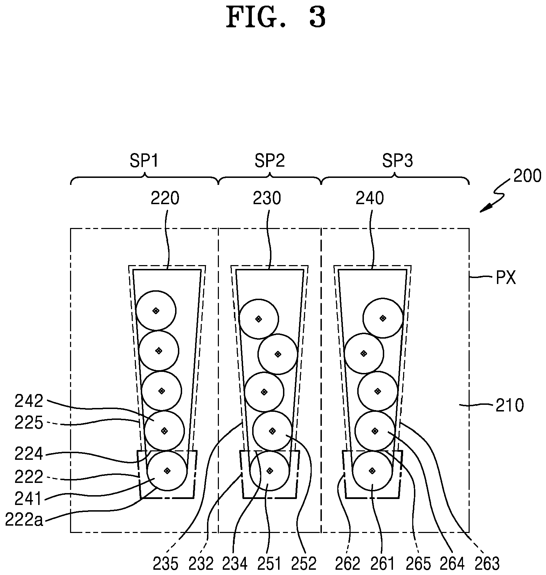

FIG. 3 illustrates one pixel of the multi-use transfer mold 200.

The multi-use transfer mold 200 may include a transfer substrate 210, a first groove 220 provided in the first sub-pixel SP1, a second groove 230 provided in the second sub-pixel SP2, and a third groove 240 provided in the third sub-pixel SP3, wherein the first through third sub-pixels SP1 through SP3 are arranged in the transfer substrate 210.

The first groove 220 may include a first transfer area 222 for accommodating a transfer micro-light-emitting device 241 and a first preliminary area 225 connected to the first transfer area 222 and having an outlet 224 through which a preliminary micro-light-emitting device 242 may pass. The first transfer area 222 may have an area for accommodating at least one transfer micro-light-emitting device 241. The size of the first transfer area 222 may be changed according to the number of micro-light-emitting devices to be transferred onto a driving substrate to be described below. That is, the size of the first transfer area 222 may be changed according to the number of micro-light-emitting devices to be arranged in one sub-pixel of a display apparatus. FIG. 3 illustrates an example in which the first transfer area 222 may have an area for accommodating one transfer micro-light-emitting device 241. The first transfer area 222 may be provided at an end of the first groove 220, and so long as the first transfer area 222 is configured such that an unintended preliminary micro-light-emitting device may not pass into the first transfer area 222, except for the transfer micro-light-emitting device 241, a shape and a size of the first transfer area 222 may be variously configured. The first transfer area 222 may include a curved surface 222a corresponding to a circular shape of the transfer micro-light-emitting device 241.

The first preliminary area 225 may be an area in which a preliminary micro-light-emitting device 242 may be accommodated while waiting for the first transfer area 222 to become empty. The first preliminary area 225 may be configured to have an area for accommodating as many preliminary micro-light-emitting devices 242 as possible. The first preliminary area 225 may have a width greater than a width of the first transfer area 222, wherein the width of the first preliminary area 225 may increase as a distance to the first transfer area 222 increases.

The second groove 230 may include a second transfer area 232 for accommodating a transfer micro-light-emitting device 251 and a second preliminary area 235 connected to the second transfer area 232 and having an outlet 234 configured to allow a preliminary micro-light-emitting device 252 to pass through. The third groove 240 may include a third transfer area 262 for accommodating the transfer micro-light-emitting device 261 and a third preliminary area 263 connected to the third transfer area 262 and having an outlet 265 through which the preliminary micro-light-emitting device 264 may pass. The second transfer area 232 and the third transfer area 262 may have substantially the same configurations and functions as the first transfer area 222 described above, and the second preliminary area 235 and the third preliminary area 263 may have substantially the same configurations and functions as the first preliminary area 225 described above. Thus, detailed descriptions of the second transfer area 232, the third transfer area 262, the second preliminary area 235 and the third preliminary area 263 are omitted.

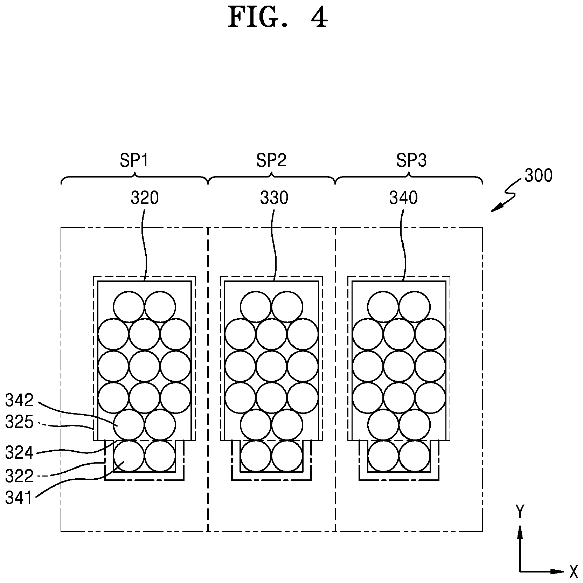

FIG. 4 illustrates a multi-use transfer mold 300 according to another example embodiment.

The multi-use transfer mold 300 may include a transfer substrate 310 and a plurality of grooves 320, 330, and 340 provided in the transfer substrate 310. The groove 320 may include a transfer area 322 for accommodating a transfer micro-light-emitting device 341 and a preliminary area 325 connected to the transfer area 322 and having an outlet 324 configured to allow a preliminary micro-light-emitting device 342 to pass through. The transfer area 322 may have a size for accommodating at least one transfer micro-light-emitting device 341, and FIG. 4 illustrates an example in which the transfer area 322 may have a size for accommodating two transfer micro-light-emitting devices 341. The transfer area 322 may be configured such that the two transfer micro-light-emitting devices 341 may be arranged in the transfer area 322 in an X direction of FIG. 4. Alternatively, the transfer area 322 may be configured such that the two transfer micro-light-emitting devices 341 may be arranged in the transfer area 322 in a Y direction of FIG. 4.

The preliminary area 325 may have a greater width than that of the transfer area 322, and the preliminary area 325 may extend from the transfer area 322 as a stair shape. Alternatively, the preliminary area 325 may extend from the transfer area 322 as a tapered shape. Alternatively, the preliminary area 325 may extend from the transfer area 322 as a straight shape.

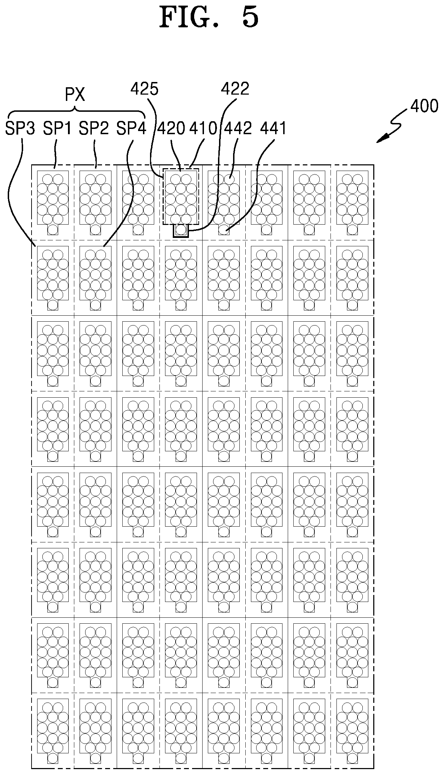

FIG. 5 is a plan view of a multi-use transfer mold 400 according to another example embodiment.

The multi-use transfer mold 400 may include a plurality of pixels PX, and each of the plurality of pixels PX may have a 2x2 sub-pixel arrangement structure. The pixel PX may include a first sub-pixel SP1, a second sub-pixel SP2, a third sub-pixel SP3, and a fourth sub-pixel SP4, and the multi-use transfer mold 400 may be applied to a pixel arrangement structure having a so-called Bayer pattern including green, blue, red, and green.

The multi-use transfer mold 400 may include a transfer substrate 410 and a plurality of grooves 420 provided in the transfer substrate 410, wherein each of the plurality of grooves 420 may include a transfer area 422 for accommodating a transfer micro-light-emitting device 441 and a preliminary area 425 for accommodating a preliminary micro-light-emitting device 442. Each of the plurality of grooves 420 may correspond to a respective sub-pixel.

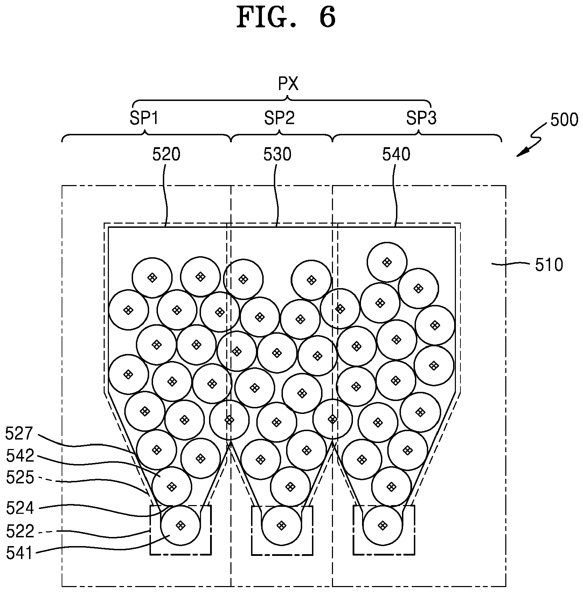

FIG. 6 illustrates a multi-use transfer mold 500 according to another example embodiment.

The multi-use transfer mold 500 may include a plurality of pixels PX, and each pixel PX may include a plurality of sub-pixels. Each of the plurality of pixels PX may include a first sub-pixel SP1, a second sub-pixel SP2, and a third sub-pixel SP3. The multi-use transfer mold 500 may include a transfer substrate 510, a first groove 520 provided in the first sub-pixel SP1, a second groove 530 provided in the second sub-pixel SP2, and a third groove 540 provided in the third sub-pixel SP3, wherein the first through third sub-pixels SP1 through SP3 are arranged in the transfer substrate 510.

Each of the first through third grooves 520 through 540 may include a transfer area 522 for accommodating a transfer micro-light-emitting device 541 and a preliminary area 525 for accommodating a preliminary micro-light-emitting device 542. The transfer area 522 of the first groove 520, the transfer area 522 of the second groove 530, and the transfer area 522 of the third groove 540 may be separate from one another. A portion of the preliminary area 525, the portion being adjacent to the transfer area 522, may have a tapered structure 527 having a decreasing width toward the transfer area 522. The tapered structure 527 may help efficiently move the preliminary micro-light-emitting device 542 to the transfer area 522.

According to an example embodiment, an integral structure of the preliminary area 525 may be formed such that at least a portion of each of the preliminary areas 525 of the first through third grooves 520 through 540 is connected to each other. When the whole or part of each of the preliminary areas 525 of the first through third grooves 520 through 540 is integral, a space for accommodating the preliminary micro-light-emitting device 542 may be relatively more widely obtained, and thus, the number of times of using the multi-use transfer mold 500 may be increased. So long as the transfer area 522 of each of the first through third grooves 520 through 540 is separate from one another, the preliminary area 525 of each of the first through third grooves 520 through 540 may have various configurations with respect to a shape, a structure, whether they are integrally formed or separately formed, etc.

In the multi-use transfer mold 500, the preliminary area 525 of the first sub-pixel SP1 and the preliminary area 525 of the third sub-pixel SP3 may have a greater area than that of the preliminary area 525 of the second sub-pixel SP2. For example, in the first sub-pixel SP1 and the third sub-pixel SP3, the tapered structure 527 of the preliminary area 525 may be asymmetrical.

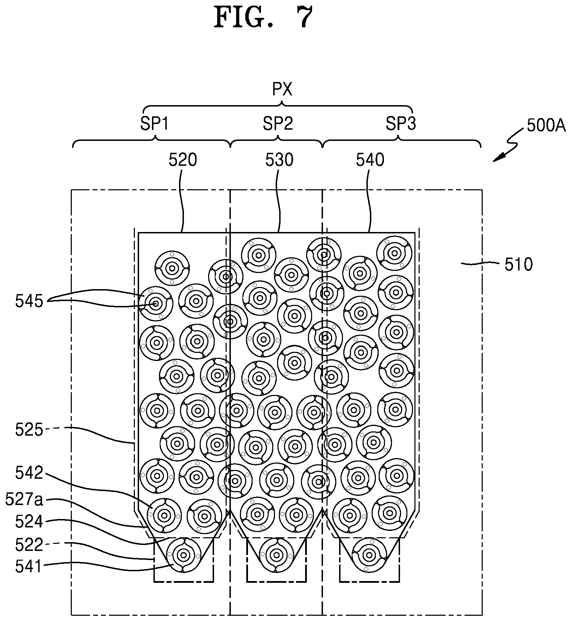

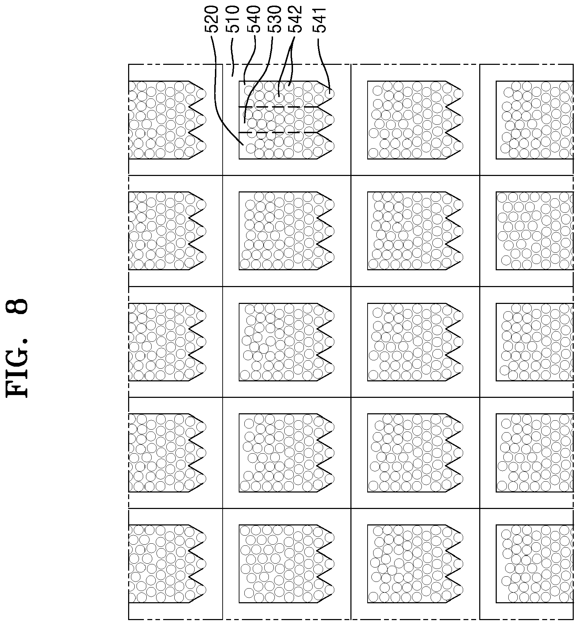

FIG. 7 illustrates a multi-use transfer mold 500A according to another example embodiment. The multi-use transfer mold 500A may have substantially the same configurations as those of the multi-use transfer mold 500 of FIG. 6, except for a tapered structure 527a. Reference numeral 545 indicates an electrode of the transfer micro-light-emitting device 541. The preliminary area 525 of each of the first through third sub-pixels SP1 through SP3 may have the same shape as one another, and the tapered structure 527a of each of the first through third sub-pixels SP1 through SP3 may be symmetrical. FIG. 8 illustrates a pixel array structure of the multi-use transfer mold 500A illustrated in FIG. 7 and indicates a state in which the transfer micro-light-emitting device 541 and the preliminary micro-light-emitting device 542 are transferred in the first through third grooves 520 through 540 of the first through third sub-pixels SP1 through SP3.

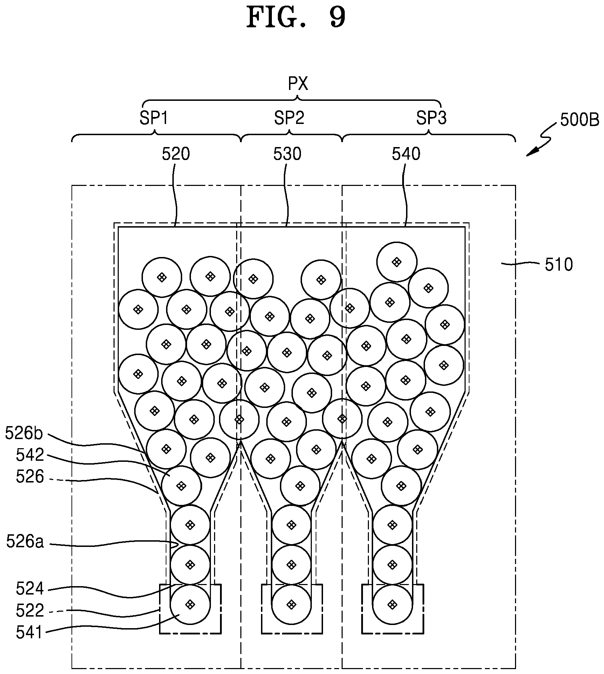

FIG. 9 illustrates a modified example of the multi-use transfer mold 500 illustrated in FIG. 6. In FIG. 9, components indicated by using the same reference numerals as the components of FIG. 6 may have substantially the same structures and functions as the components of FIG. 6, and thus, their detailed descriptions are omitted here.

A multi-use transfer mold 500B may include the transfer area 522 and a preliminary area 526 in each of the first through third sub-pixels SP1 through SP3. A portion of the preliminary area 526, the portion being adjacent to the transfer area 522, may have a straight-shaped structure 526a having the same width as that of the transfer area 522, and a portion of the preliminary area 526, the portion being adjacent to the straight-shaped structure 526a of the preliminary area 526 may have a tapered structure 526b having a decreasing width toward the straight-shaped structure 526a. It is described that the preliminary area 526 may have the straight-shaped structure 526a and the tapered structure 526b. However, according to necessity, the preliminary area 526 may have the tapered structure 526b, and the transfer area 522 may have a straight-shaped structure for accommodating the three transfer micro-light-emitting devices 541.

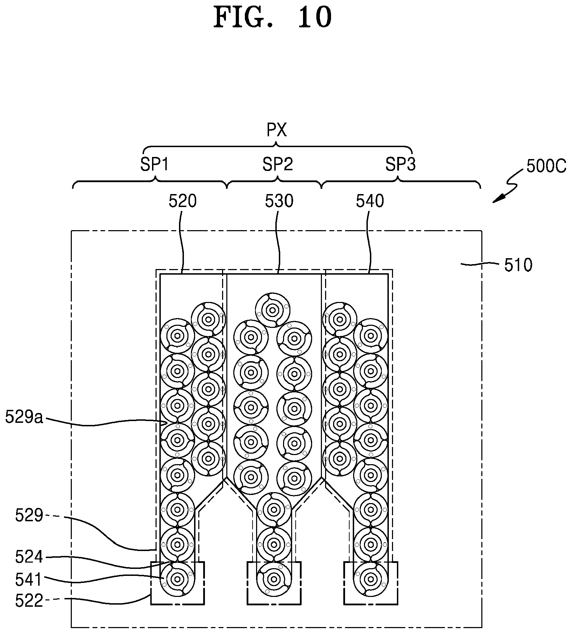

FIG. 10 illustrates a modified example of the multi-use transfer mold 500B illustrated in FIG. 9.

A multi-use transfer mold 500C may have the same configurations as those of the multi-use transfer mold 500B of FIG. 9, except for a structure in which the transfer area 522 and a preliminary area 529 of each of the first sub-pixel SP1 and the third sub-pixel SP3 may have a straight line 529a at a respective side.

As described above, a multi-use transfer mold according to an embodiment may have various structures, shapes, and sizes, as long as a transfer area for accommodating a transfer micro-light-emitting device in each sub-pixel is separately formed for each sub-pixel unit. Because micro-light-emitting devices may be transferred onto different driving substrates a plurality of times by using the multi-use transfer mold, the cost of manufacturing may be reduced and the yield rate may be increased.

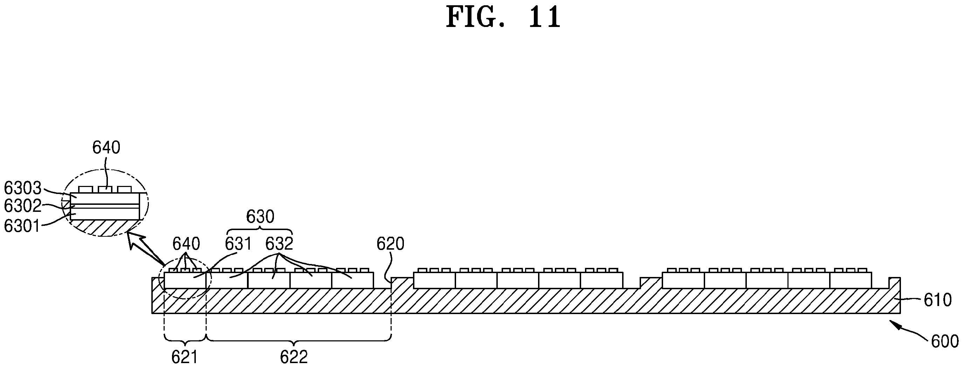

With reference to FIGS. 11 through 17, a method of manufacturing a display apparatus, according to an example embodiment, will be described.

Referring to FIG. 11, a multi-use transfer mold 600 including a transfer substrate 610 and a groove 620 provided in the transfer substrate 610 may be prepared. For the multi-use transfer mold 600, various embodiments described with reference to FIGS. 1 through 10 may be applied. A micro-light-emitting device 630 may be supplied in the groove 620 of the transfer substrate 610. The transfer substrate 610 may include the groove 620 in a multiple number, and each of the grooves 620 may include a transfer area 621 and a preliminary area 622. The micro-light-emitting devices 630 may be arranged on the transfer substrate 610 by using a transfer method. The micro-light-emitting devices 630 may include a transfer micro-light-emitting device 631 arranged in the transfer area 621 and a preliminary micro-light-emitting device 632 arranged in the preliminary area 622. The micro-light-emitting devices 630 may each include a first semiconductor layer 6301, an emission layer 6302, and a second semiconductor layer 6303 that are sequentially stacked. For example, the first semiconductor layer 6301 may include an n-type semiconductor. The first semiconductor layer 6301 may include Groups III-V-based n-type semiconductors, for example, n-GaN. The first semiconductor layer 6301 may have a single-layered or multi-layered structure.

The emission layer 6302 may be provided on an upper surface of the first semiconductor layer 6301. The emission layer 6302 may emit light via the unification of electrons and holes. The emission layer 6302 may have a multi-quantum well (MQW) structure or a single-quantum well (SQW) structure. The emission layer 6302 may include Groups III-V-based semiconductors, for example, GaN.

The second semiconductor layer 6303 may be arranged on an upper surface of the emission layer 6302. The second semiconductor layer 6303 may include, for example, a p-type semiconductor. The second semiconductor layer 6303 may include Groups III-V-based p-type semiconductors, for example, p-GaN. The second semiconductor layer 6303 may have a single-layered or multi-layered structure. Alternatively, when the first semiconductor layer 6301 includes a p-type semiconductor, the second semiconductor layer 6303 may include an n-type semiconductor. The micro-light-emitting device 630 may have a horizontal electrode structure, and an electrode 640 may be provided on the second semiconductor layer 6303. The micro-light-emitting device 630 may have a width that is, for example, equal to or less than 200 µm. Also, a depth of the groove 620 may be less than a thickness of the micro-light-emitting device 630 such that the electrode 640 of the micro-light-emitting device 630 may protrude outwardly from the groove 620.

As a transferring method, a pick and place method, a stamping method, a fluid self-assembly method, etc. may be used.

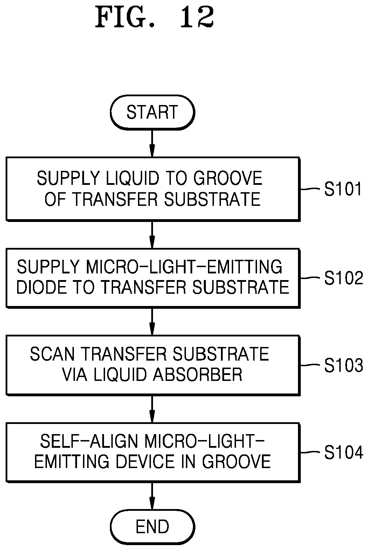

Referring to FIG. 12, a method of transferring the micro-light-emitting device 630 onto the transfer substrate 610 of FIG. 11 by using a fluid self-assembly method is described. In order to transfer the micro-light-emitting device 630 to the groove 620, a liquid may be supplied to the groove 620 (S101). The liquid may include any types of liquids that do not corrode or damage the micro-light-emitting device 630. The liquid may include, for example, one or a combination from a group consisting of water, ethanol, alcohol, polyol, ketone, halocarbon, acetone, a flux, and an organic solvent. The organic solvent may include, for example, isopropyl alcohol (IPA). The available liquid is not limited thereto and may be variously modified.

Methods of supplying the liquid to the plurality of grooves 620 may include various methods. For example, spraying, dispensing, inkjet dot spreading, a method of spilling the liquid onto the transfer substrate 610, etc. may be used. A supply amount of the liquid may be variously adjusted. For example, an amount of the liquid may be provided to fill exactly the plurality of grooves 620 or to spill over the grooves 620.

The micro-light-emitting devices 630 in a multiple number may be supplied onto the transfer substrate 610 (S102). The micro-light-emitting device 630 may be directly sprinkled over the transfer substrate 610 without other liquids or may be supplied onto the transfer substrate 610 by being included in a suspension. Methods of supplying the micro-light-emitting device 630 included in the suspension may include various methods. For example, spraying, dispensing that drips a liquid, inkjet dot spreading that discharges a liquid like a printing method, a method of spilling the suspension onto the transfer substrate 610, etc. may be used. Also, the transfer substrate 610 may be scanned by an absorber capable of absorbing the liquid (S103). The absorber may include any types of materials capable of absorbing a liquid, and a shape or a structure of the absorber is not particularly limited. The absorber may include, for example, fabric, a tissue, a polyester fiber, paper, a wiper, or the like.

The absorber may scan the transfer substrate 610 by pressurizing the transfer substrate 610 by applying an appropriate pressure to the transfer substrate 610. The scanning may include liquid absorption of the absorber by passing through the groove 620 in contact with the transfer substrate 610. The scanning may be performed based on various methods including, for example, sliding, rotating, translating, reciprocating, rolling, spinning, and/or rubbing of the absorber. Here, the methods may include both regular movements and irregular movements. The scanning may be performed by moving the transfer substrate 610 rather than the absorber. The scanning of the transfer substrate 610 may also be performed based on sliding, rotation, translation, reciprocation, rolling, spinning, rubbing, or the like. However, the scanning may also be performed based on a collaborative movement of the absorber and the transfer substrate 610. Based on the method described above, the micro-light-emitting device 630 may be aligned in the groove 620 of the transfer substrate 610 by using the fluid self-assembly method (S104).

When the micro-light-emitting device 630 is aligned in the groove 620, the micro-light-emitting device 630 may be arranged such that the electrode 640 of the micro-light-emitting device 630 is in an upper direction. The electrode 640 of the micro-light-emitting device 630 may be arranged in the upper direction, and the micro-light-emitting device 630 may have a flat lower surface, and thus, a roughness between an upper portion and a lower portion of the micro-light-emitting device 630 may be different, to cause a difference in surface energy. Thus, when the liquid absorber scans the transfer substrate 610 by absorbing the liquid, upper and lower locations of the micro-light-emitting device 630 may be guided. According to a liquid flow during the scanning of the liquid absorber, a surface of the micro-light-emitting device 630, the surface having a relatively greater roughness, may be arranged in an upper direction, and a surface of the micro-light-emitting device 630, the surface having a relatively less roughness, may be arranged in a lower direction.

By moving the micro-light-emitting devices 630 to the groove 620, the transfer micro-light-emitting device 631 may be aligned in the transfer area 621, and the preliminary micro-light-emitting device 632 may be aligned in the preliminary area 622.

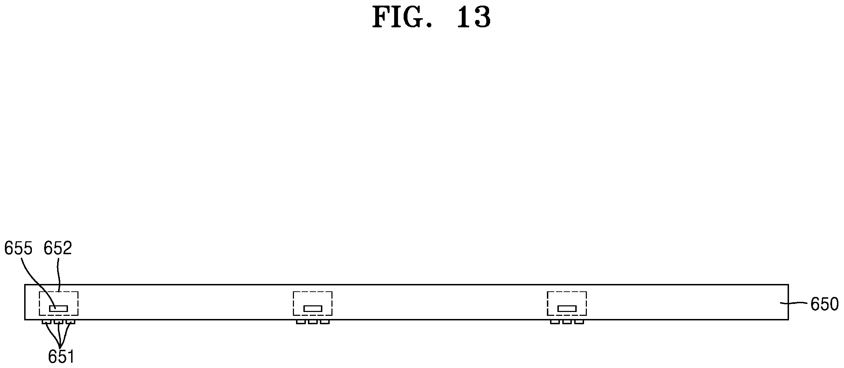

Referring to FIG. 13, a first driving substrate 650 may be provided. The first driving substrate 650 may include a driving device 652 configured to drive the micro-light-emitting device 630. The driving device 652 may include a transistor, a capacitor, and the like, and an electrode pad 651 electrically connected to the driving device 652 may be provided on a surface of the first driving substrate 650. The electrode pad 651 may protrude from the surface of the first driving substrate 650, and the first driving substrate 650 may include an alignment mark 655.

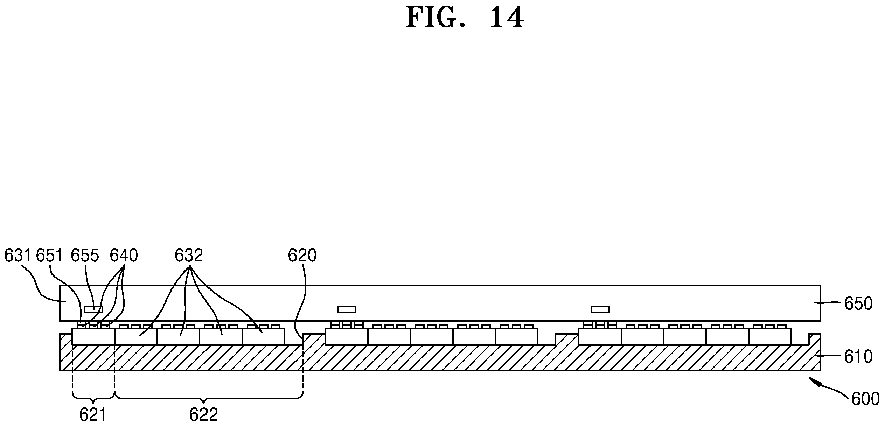

Referring to FIG. 14, the first driving substrate 650 may be arranged to face the transfer substrate 610, and the electrode pad 651 may be aligned to meet the electrode 640 of the transfer micro-light-emitting device 631 corresponding to the electrode pad 651. The first driving substrate 650 may be arranged based on the alignment mark 655 to match the electrode pad 651 to the electrode 640 corresponding to the electrode pad 651.

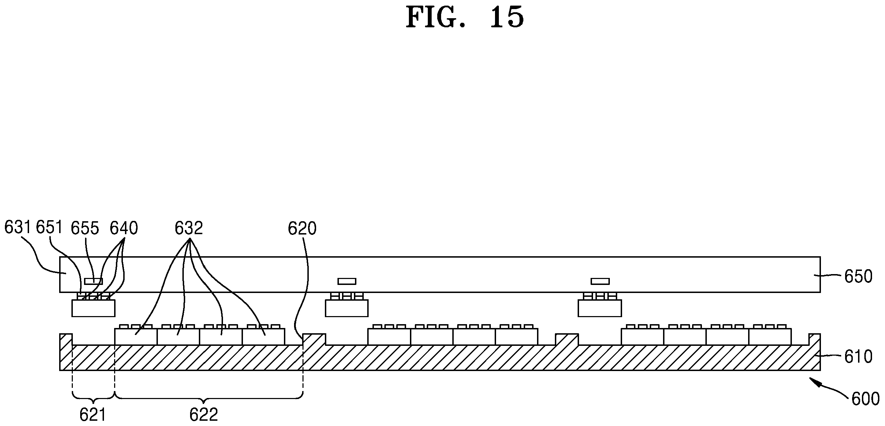

Referring to FIG. 15, the electrode 640 and the electrode pad 651 corresponding to the electrode 640 may be bonded to each other, and the first driving substrate 650 may be moved to perform a bonding-transfer of the transfer micro-light-emitting device 631 to a pixel area of the first driving substrate 650, the pixel area corresponding to the transfer micro-light-emitting device 631. When the transfer micro-light-emitting device 631 is bonding-transferred to the first driving substrate 650, the transfer area 621 of the groove 620 may become an empty space.

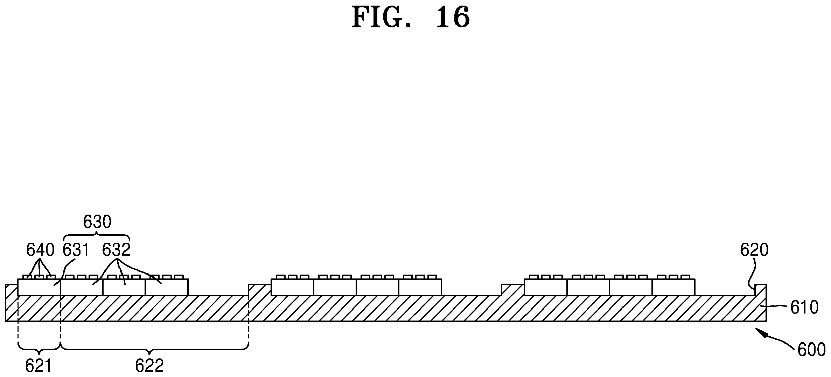

Referring to FIG. 16, by moving the first preliminary micro-light-emitting device 632 to the transfer area 621 of the transfer substrate 610 after the transfer area 621 has become empty, the first preliminary micro-light-emitting device becomes another transfer micro-light-emitting device 631 arranged in the transfer area 621. When the preliminary micro-light-emitting device 632 is moved to the transfer area 621, remaining preliminary micro-light-emitting devices 632 may be generally shifted, and one preliminary micro-light-emitting device 632 may be moved to the transfer area 621.

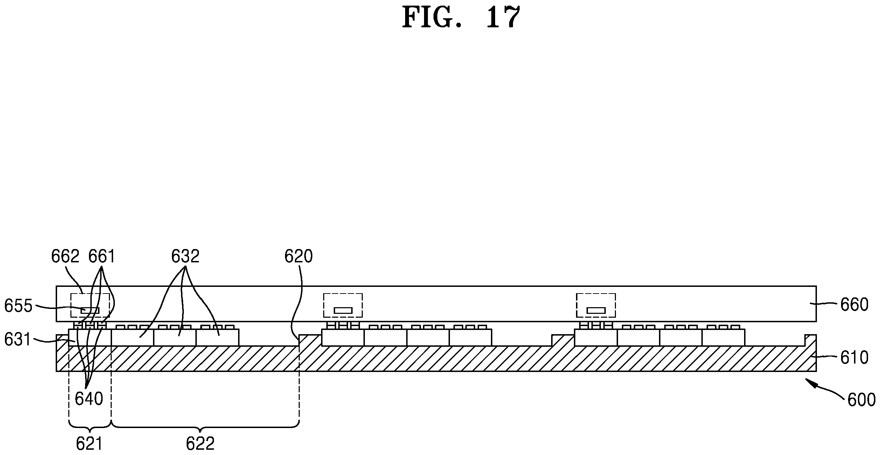

Referring to FIG. 17, a second driving substrate 660 may be provided. The second driving substrate 660 may include a driving device 662 configured to drive the micro-light-emitting device 630. An electrode pad 661 electrically connected to the driving device 662 may be provided on a surface of the second driving substrate 660, and the second driving substrate 660 may include the alignment mark 655.

The second driving substrate 660 may be arranged to face the transfer substrate 610, and the electrode pad 661 may be aligned to meet the electrode 640 of the transfer micro-light-emitting device 631 corresponding to the electrode pad 661. The electrode 640 and the electrode pad 661 corresponding to the electrode 640 may be bonded to each other, and the second driving substrate 660 may be moved to perform a bonding-transfer of the transfer micro-light-emitting device 631 to a pixel area of the second driving substrate 660, the pixel area corresponding to the transfer micro-light-emitting device 631. By using this method, the micro-light-emitting device 630 may be transferred onto a plurality of driving substrates until complete exhaustion of the preliminary micro-light-emitting devices 632 remaining in the groove 620.

According to the method of manufacturing a display apparatus, according to an example embodiment, a plurality of display apparatuses may be manufactured by using the multi-use transfer mold 600 a plurality of times. Since the multi-use transfer mold 600 may be used a plurality of times, the transfer time and costs may be reduced. Also, the micro-light-emitting devices 630 may be easily pushed into the transfer area 621 of the multi-use transfer mold 600, and thus, a possibility of a leakage of the transfer micro-light-emitting device 631 in the transfer area 621 may be reduced. Thus, a pixel error rate and a repair process in the display apparatus may be reduced.

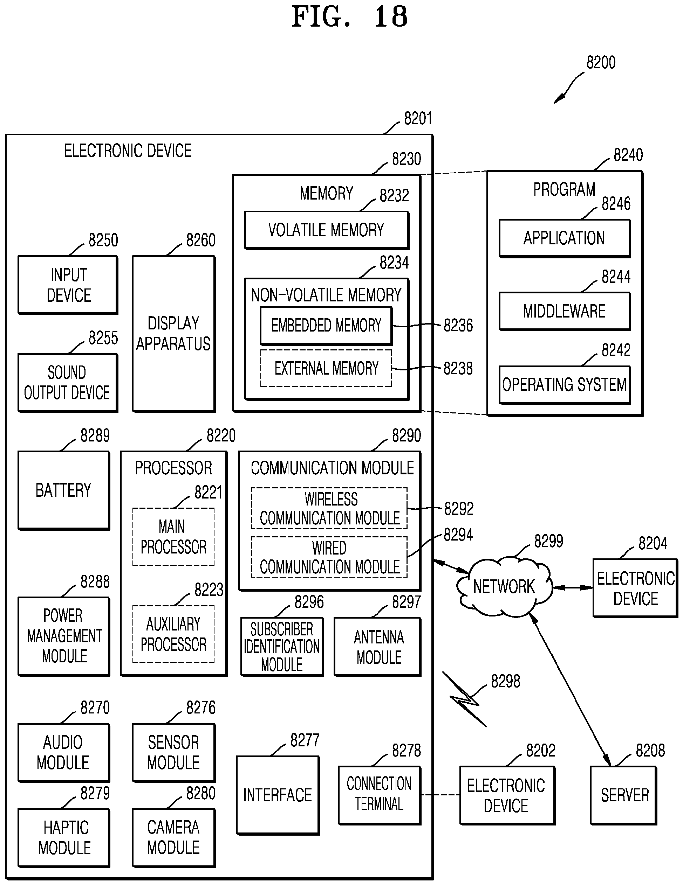

FIG. 18 is a block diagram of an electronic device 8201 including a display apparatus according to an example embodiment.

Referring to FIG. 18, the electronic device 8201 may be provided in a network environment 8200. In the network environment 8200, the electronic device 8201 may communicate with another electronic device 8202 through a first network 8298 (a short-range wireless communication network, etc.) or communicate with another electronic device 8204 and/or a server 8208 through a second network 8299 (a remote wireless communication network, etc.). The electronic device 8201 may communicate with the electronic device 8204 through the server 8208. The electronic device 8201 may include a processor 8220, a memory 8230, an input device 8250, a sound output device 8255, a display apparatus 8260, an audio module 8270, a sensor module 8276, an interface 8277, a haptic module 8279, a camera module 8280, a power management module 8288, a battery 8289, a communication module 8290, a subscriber identification module 8296, and/or an antenna module 8297. The electronic device 8201 may omit one or more of the components or may further include other components. One or more of the components may be realized as an integrated circuit. For example, the sensor module 8276 (a fingerprint sensor, an iris sensor, an illumination sensor, etc.) may be embedded in the display apparatus 8269 (a display, etc.).

The processor 8220 may be configured to execute software (a program 8240, etc.) to control one or more components (hardware or software components) of the electronic device 8201, the components being connected to the processor 8220, and to perform various data processing or calculations. As part of the data processing or calculations, the processor 8220 may be configured to load a command and/or data received from other components (the sensor module 8276, the communication module 8290, etc.) into the volatile memory 8232, process the command and/or the data stored in a volatile memory 8232, and store resultant data in a nonvolatile memory 8234. The nonvolatile memory 8234 may include an embedded memory 8236 and an external memory 8238. The processor 8220 may include a main processor 8221 (a central processing unit (CPU), an application processor (AP), etc.) and an auxiliary processor 8223 (a graphics processing unit (GPU), an image signal processor, a sensor hub processor, a communication processor, etc.) which may independently operate or operate with the main processor 8221. The auxiliary processor 8223 may use less power than the main processor 8221 and may perform specialized functions.

When the main processor 8221 is in an inactive state (a sleep state), the auxiliary processor 8223 may take charge of an operation of controlling functions and/or states related to one or more components (the display apparatus 8260, the sensor module 8276, the communication module 8290, etc.) from among the components of the electronic device 8201, or when the main processor 8221 is in an active state (an application execution state), the auxiliary processor 8223 may perform the same operation along with the main processor 8221. The auxiliary processor 8223 (the image signal processor, the communication processor, etc.) may be realized as part of other functionally-related components (the camera module 8280, the communication module 8290, etc.).

The memory 8230 may store various data required by the components (the processor 8220, the sensor module 8276, etc.) of the electronic device 8201. The data may include, for example, software (the program 8240, etc.), input data and/or output data of a command related to the software. The memory 8230 may include the volatile memory 8232 and/or the nonvolatile memory 8234.

The program 8240 may be stored in the memory 8230 as software, and may include an operating system 8242, middleware 8244, and/or an application 8246.

The input device 8250 may receive a command and/or data to be used by the components (the processor 8220, etc.) of the electronic device 8201 from the outside of the electronic device 8201. The input device 8250 may include a remote controller, a microphone, a mouse, a keyboard, and/or a digital pen (a stylus pen, etc.).

The sound output device 8255 may output a sound signal to the outside of the electronic device 8201. The sound output device 8255 may include a speaker and/or a receiver. The speaker may be used for a general purpose, such as multimedia playing or recording playing, and the receiver may be used to receive an incoming call. The receiver may be coupled to the speaker as part of the speaker or may be realized as a separate device.

The display apparatus 8260 may visually provide information to the outside of the electronic device 8201. The display apparatus 8260 may include a display, a hologram device, or a controlling circuit for controlling a projector and a corresponding device. The display apparatus 8260 may include a display apparatus described with reference to FIGS. 1 through 13 and may be manufactured by using the method of manufacturing the display apparatus described with reference to FIGS. 14 through 17. The display apparatus 8260 may include touch circuitry configured to sense a touch operation and/or sensor circuitry (a pressure sensor, etc.) configured to measure an intensity of a force generated by the touch operation.

The audio module 8270 may convert sound into an electrical signal or an electrical signal into sound. The audio module 8270 may obtain sound via the input device 8250 or may output sound via the sound output device 8255 and/or a speaker and/or a headphone of an electronic device (the electronic device 8202, etc.) directly or wirelessly connected to the electronic device 8201.

The sensor module 8276 may sense an operation state (power, temperature, etc.) of the electronic device 8201 or an external environmental state (a user state, etc.) and generate electrical signals and/or data values corresponding to the sensed state. The sensor module 8276 may include a gesture sensor, a gyro-sensor, an atmospheric sensor, a magnetic sensor, an acceleration sensor, a grip sensor, a proximity sensor, a color sensor, an infrared (IR) sensor, a biometric sensor, a temperature sensor, a humidity sensor, and/or an illumination sensor.

The interface 8277 may support one or more designated protocols to be used for the electronic device 8201 to be directly or wirelessly connected to another electronic device (the electronic device 8202, etc.). The interface 8277 may include a high-definition multimedia interface (HDMI) interface, a universal serial bus (USB) interface, an SD card interface, and/or an audio interface.

A connection terminal 8278 may include a connector, through which the electronic device 8201 may be physically connected to another electronic device (the electronic device 8202, etc.). The connection terminal 8278 may include an HDMI connector, a USB connector, an SD card connector, and/or an audio connector (a headphone connector, etc.).

A haptic module 8279 may convert an electrical signal into a mechanical stimulus (vibration, motion, etc.) or an electrical stimulus which is recognizable to a user via haptic or motion sensation. The haptic module 8279 may include a motor, a piezoelectric device, and/or an electrical stimulus device.

The camera module 8280 may capture a still image and a video. The camera module 8280 may include a lens assembly including one or more lenses, image sensors, image signal processors, and/or flashes. The lens assemblies included in the camera module 8280 may collect light emitted from an object, an image of which is to be captured.

The power management module 8288 may manage power supplied to the electronic device 8201. The power management module 8388 may be realized as part of a power management integrated circuit (PMIC).

The battery 8289 may supply power to the components of the electronic device 8201. The battery 8289 may include a non-rechargeable primary battery, rechargeable secondary battery, and/or a fuel battery.

The communication module 8290 may support establishment of direct (wired) communication channels and/or wireless communication channels between the electronic device 8201 and other electronic devices (the electronic device 8202, the electronic device 8204, the server 8208, etc.) and communication performance through the established communication channels. The communication module 8290 may include one or more communication processors separately operating from the processor 8220 (an application processor, etc.) and supporting direct communication and/or wireless communication. The communication module 8290 may include a wireless communication module 8292 (a cellular communication module, a short-range wireless communication module, a global navigation satellite system (GNSS) communication module, and/or a wired communication module 8294 (a local area network (LAN) communication module, a power line communication module, etc.). From these communication modules, a corresponding communication module may communicate with other electronic devices through a first network 8298 (a short-range wireless communication network, such as Bluetooth, WiFi direct, or infrared data association (IrDa)) or a second network 8299 (a remote communication network, such as a cellular network, the Internet, or a computer network (LAN, WAN, etc.)). Various types of communication modules described above may be integrated as a single component (a single chip, etc.) or realized as a plurality of components (a plurality of chips). The wireless communication module 8292 may identify and authenticate the electronic device 8201 within the first network 8298 and/or the second network 8299 by using subscriber information (international mobile subscriber identification (IMSI), etc.) stored in the subscriber identification module 8296.

The antenna module 8297 may transmit a signal and/or power to the outside (other electronic devices, etc.) or receive the same from the outside. The antenna may include an emitter including a conductive pattern formed on a substrate (a printed circuit board (PCB), etc.). The antenna module 8297 may include an antenna or a plurality of antennas. When the antenna module 8297 includes a plurality of antennas, an appropriate antenna which is suitable for a communication method used in the communication networks, such as the first network 8298 and/or the second network 8299, may be selected. Through the selected antenna, signals and/or power may be transmitted or received between the communication module 8290 and other electronic devices. In addition to the antenna, another component (a radio frequency integrated circuit (RFIC), etc.) may be included in the antenna module 8297.

One or more of the components of the electronic device 2201 may be connected to one another and exchange signals (commands, data, etc.) with one another, through communication methods performed among peripheral devices (a bus, general purpose input and output (GPIO), a serial peripheral interface (SPI), a mobile industry processor interface (MIPI), etc.).

The command or the data may be transmitted or received between the electronic device 8201 and another external electronic device 8204 through the server 8208 connected to the second network 8299. Other electronic devices 8202 and 8204 may be electronic devices that are homogeneous or heterogeneous types with respect to the electronic device 8201. All or part of operations performed in the electronic device 8201 may be performed by one or more of the other electronic devices 8202, 8204, and 8208. For example, when the electronic device 8201 has to perform a function or a service, instead of directly performing the function or the service, the one or more other electronic devices may be requested to perform part or all of the function or the service. The one or more other electronic devices receiving the request may perform an additional function or service related to the request and may transmit a result of the execution to the electronic device 8201. To this end, cloud computing, distribution computing, and/or client-server computing techniques may be used.

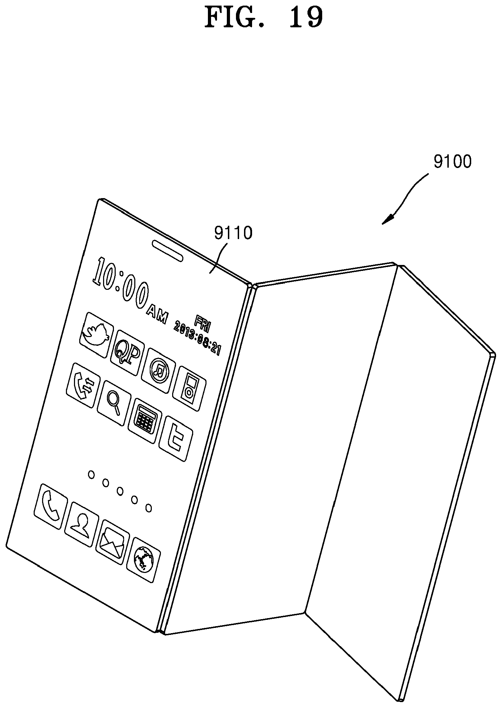

FIG. 19 illustrates an example in which an electronic device according to an example embodiment is applied to a mobile device 9100. The mobile device 9100 may include a display apparatus 9110, and the display apparatus 9110 may include a display apparatus manufactured by using the method of manufacturing a display apparatus described with reference to FIGS. 11 through 17. The display apparatus 9110 may have a foldable structure, for example, a multi-foldable structure.

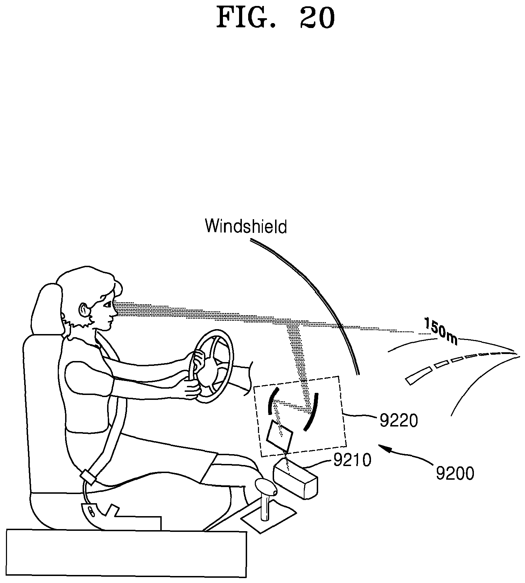

FIG. 20 illustrates an example in which a display apparatus according to an example embodiment is applied to a vehicle. The display apparatus may correspond to a vehicle head up display apparatus 9200 and may include a display 9210 provided in a region of the vehicle and an optical path-change member 9220 configured to convert an optical path for a driver to watch an image generated by the display 9210.

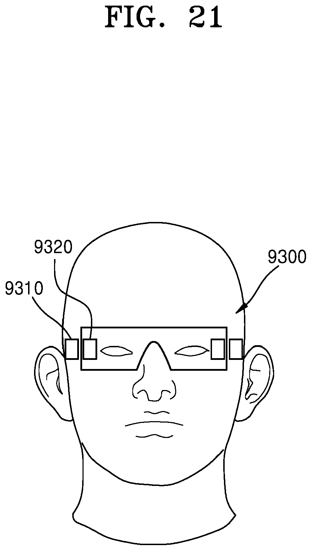

FIG. 21 illustrates an example in which a display apparatus according to an example embodiment is applied to augmented reality (AR) glasses or virtual reality (VR) glasses 9300. The AR glasses 9300 may include a projection system 9310 configured to form an image and a component 9320 configured to guide an image from the projection system 9310 to the eye of a user. The projection system 9310 may include the display apparatus described with reference to FIGS. 5 through 8.

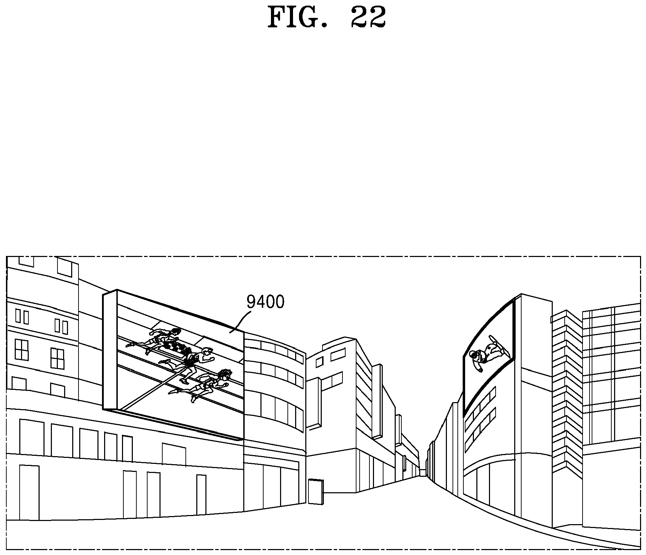

FIG. 22 illustrates an example in which a display apparatus according to an example embodiment is applied to a large signage 9400. The signage 9400 may be used for outdoor advertising using digital information display and may control advertisement content through a communication network. The signage 9400 may be realized for example by the electronic device described with reference to FIG. 18.

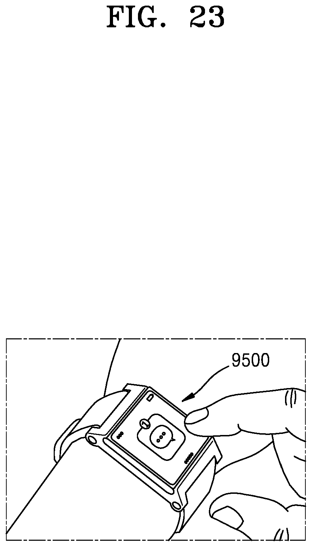

FIG. 23 is a diagram of an example in which a display apparatus according to an example embodiment is applied to a wearable display. The wearable display 9500 may include a display apparatus manufactured by using the method of manufacturing a display apparatus described with reference to FIGS. 11 through 17 or may be realized by the electronic device 8201 described with reference to FIG. 18.

The display apparatus according to an example embodiment may be applied to other various products, such as a rollable television (TV), a stretchable display, etc.

The embodiments described above are only examples. One of ordinary skill in the art may understand that various modifications and equivalent embodiments are possible based on the embodiments. Thus, the true technical protection range according to the embodiments shall be defined by the technical concept of the disclosure stated in the claims below.

A multi-use transfer mold according to an example embodiment may efficiently transfer micro-light-emitting devices onto a driving substrate and may be used a plurality of times. The multi-use transfer mold may include a plurality of grooves, each of which may include a transfer area for accommodating the micro-light-emitting devices to be transferred onto the driving substrate and a preliminary area for accommodating the micro-light-emitting devices to be preliminarily transferred onto the driving substrate. Thus, the transfer mold may be used a plurality of times, and a yield rate may be increased.

According to a method of manufacturing a display apparatus, according to an example embodiment, the micro-light-emitting devices may be efficiently transferred onto the driving substrate by using the multi-use transfer mold, and the multi-use transfer mold may be used a plurality of times to manufacture a display apparatus.

It should be understood that embodiments described herein should be considered in a descriptive sense only and not for purposes of limitation. While one or more embodiments have been described with reference to the figures, it will be understood by those of ordinary skill in the art that various changes in form and details may be made therein without departing from the scope of the present invention as defined by the following claims.

## Claims

1. A multi-use transfer mold (100) comprising:
a transfer substrate (110) comprising a plurality of pixels (PX), and a first groove (120) and a second groove (130) provided in each of the plurality of pixels,
wherein the first groove comprises a first transfer area (122) configured to accommodate a transfer micro-light-emitting device (141), and a first preliminary area (125) connected to the first transfer area and configured to accommodate a preliminary micro-light-emitting device (142),
wherein the first preliminary area comprises a first outlet (124) configured to allow the preliminary micro-light-emitting device to move to the first transfer area,
wherein the second groove comprises a second transfer area (132) configured to accommodate the transfer micro-light-emitting device, and a second preliminary area (135) connected to the second transfer area and configured to accommodate the preliminary micro-light-emitting device, and
wherein the second preliminary area comprises a second outlet (134) configured to allow the preliminary micro-light-emitting device to move to the second transfer area.

2. The multi-use transfer mold (100) of claim 1, wherein the first transfer area (122) and the second transfer area (132) are spaced apart from each other.

3. The multi-use transfer mold (100) of claim 1, wherein at least a portion of the first preliminary area (125) and at least a portion of the second preliminary area (135) are integral with each other.

4. The multi-use transfer mold (100) of claim 1, wherein a portion of the first preliminary area (125), that is adjacent to the first transfer area(122), has a tapered structure having a width decreasing toward the first transfer area, and
wherein a portion of the second preliminary area (135), that is adjacent to the second transfer area (132), has a tapered structure having a width decreasing toward the second transfer area.

5. The multi-use transfer mold (100) of claim 1, wherein a portion of the first preliminary area (125), that is adjacent to the first transfer area (122), has a straight-shaped structure having a width that is the same as a width of the first transfer area, and
wherein a portion of the second preliminary area (135), that is adjacent to the second transfer area (132), has a straight-shaped structure having a width that is the same as a width of the second transfer area.

6. The multi-use transfer mold (100) of claim 1, wherein a first portion of the first preliminary area (125), that is adjacent to the first transfer area (122), has a straight-shaped structure having a width that is the same as a width of the first transfer area,
wherein a second portion of the first preliminary area, that is adjacent to the first portion of the first preliminary area, has a tapered structure having a width decreasing toward the first portion of the first preliminary area,
wherein a first portion of the second preliminary area (135), that is adjacent to the second transfer area (132), has a straight-shaped structure having a width that is the same as a width of the second transfer area, and
wherein a second portion of the second preliminary area, that is adjacent to the first portion of the second preliminary area, has a tapered structure having a width decreasing toward the first portion of the second preliminary area.

7. The multi-use transfer mold (100) of claim 1, wherein each of the first transfer area (122) and the second transfer area (132) has a width that is greater than a width of the transfer micro-light-emitting device (141) and less than twice the width of the transfer micro-light-emitting device.

8. The multi-use transfer mold (100) of claim 1, wherein each of the plurality of pixels (PX) includes a plurality of sub-pixels (SP1, SP2, SP3, SP4), and
wherein each of the first transfer area (122) and the second transfer area (132) has a size corresponding to a number of transfer micro-light-emitting devices (141) included in each of the plurality of sub-pixels.

9. The multi-use transfer mold (100) of claim 1, wherein the first preliminary area (125) has a width that is equal to or greater than a width of the first transfer area (122), and
wherein the second preliminary area (135) has a width that is equal to or greater than a width of the second transfer area (132).

10. A method of manufacturing a display apparatus, the method comprising:
preparing a transfer substrate (110) of a multi-use transfer mold (100) comprising a plurality of pixels (PX), each of the plurality of pixels comprising a first groove (120) and a second groove (130), wherein the first and second grooves comprise a first and second transfer area (122, 132) and a first and second preliminary area (125, 135) respectively, wherein the first and second preliminary areas comprise first and second outlets (124, 134) respectively configured to allow a preliminary micro-light-emitting device (142) to move to the first and second transfer areas respectively;
supplying preliminary micro-light-emitting devices and transfer micro-light-emitting devices (141) to each of the first and second grooves of each of the plurality of pixels;
aligning the transfer micro-light-emitting devices on the transfer areas and aligning the preliminary micro-light-emitting devices on the preliminary areas;
bonding-transferring the transfer micro-light-emitting devices to a pixel of a first driving substrate (650), the pixel of the first driving substrate corresponding to the transfer micro-light-emitting devices;
moving the preliminary micro-light-emitting devices to the transfer areas, which is empty after the transfer micro-light-emitting devices are bond-transferred to the pixel of the first driving substrate; and
bonding-transferring the preliminary micro-light-emitting devices moved to the transfer areas to a pixel of a second driving substrate (660), the pixel of the second driving substrate corresponding to the preliminary micro-light-emitting devices.

11. The method of claim 10, wherein each of the plurality of pixels (PX) includes a plurality of sub-pixels (SP1, SP2, SP3, SP4),
wherein the first groove and the second groove are included in respective sub-pixels of the plurality of sub-pixels,
wherein the first transfer area (122) of the first groove (120) is configured to accommodate the transfer micro-light-emitting device (141), and the first preliminary area (125) connected to the first transfer area is configured to accommodate the preliminary micro-light-emitting device (142),
wherein the second transfer area (132) of the second groove (130) is configured to accommodate the transfer micro-light-emitting device (141), and the second preliminary area (135) connected to the second transfer area is configured to accommodate the preliminary micro-light-emitting device.

12. The method of claim 10 or 11, wherein a portion of the first preliminary area (125), that is adjacent to the first transfer area (122), has a straight-shaped structure having a width that is the same as a width of the first transfer area.

13. The method of claim 10, 11 or 12, wherein a first portion of the first preliminary area (125), that is adjacent to the first transfer area (122), has a straight-shaped structure having a width that is the same as a width of the transfer area, and
wherein a second portion of the first preliminary area, that is adjacent to the portion of the first preliminary area, has a tapered structure having a width decreasing toward the first portion of the first preliminary area.

14. The method of any of claims 10 to 13, wherein the first transfer area (122) has a width that is greater than a width of the transfer micro-light-emitting device (141) and less than twice the width of the transfer micro-light-emitting device.

15. The method of any of claims 10 to 14, wherein each of the plurality of pixels (PX) comprises a plurality of sub-pixels (SP1, SP2, SP3, SP4), and
wherein the first transfer area (122) has a size corresponding to a number of transfer micro-light-emitting devices (141) included in each of the plurality of sub-pixels.

## Patentansprüche

1. Mehrzweck-Transferform (100), umfassend:
ein Transfersubstrat (110), das eine Vielzahl von Pixeln (PX) und eine erste Nut (120) und eine zweite Nut (130) umfasst, die in jedem der Vielzahl von Pixeln bereitgestellt sind,
wobei die erste Nut einen ersten Transferbereich (122), der zum Aufnehmen einer mikrolichtemittierenden Transfereinrichtung (141) konfiguriert ist, und einen ersten vorläufigen Bereich (125) umfasst, der mit dem ersten Transferbereich verbunden ist und zum Aufnehmen einer vorläufigen mikrolichtemittierenden Einrichtung (142) konfiguriert ist,
wobei der erste vorläufige Bereich einen ersten Auslass (124) umfasst, der dazu konfiguriert ist, zu ermöglichen, dass sich die vorläufige mikrolichtemittierende Einrichtung zu dem ersten Transferbereich bewegt,
wobei die zweite Nut einen zweiten Transferbereich (132), der zum Aufnehmen der mikrolichtemittierenden Transfereinrichtung konfiguriert ist, und einen zweiten vorläufigen Bereich (135) umfasst, der mit dem zweiten Transferbereich verbunden ist und zum Aufnehmen der vorläufigen mikrolichtemittierenden Einrichtung konfiguriert ist, und
wobei der zweite vorläufige Bereich einen zweiten Auslass (134) umfasst, der dazu konfiguriert ist, zu ermöglichen, dass sich die vorläufige mikrolichtemittierende Einrichtung zu dem zweiten Transferbereich bewegt.

2. Mehrzweck-Transferform (100) nach Anspruch 1, wobei der erste Transferbereich (122) und der zweite Transferbereich (132) voneinander beabstandet sind.

3. Mehrzweck-Transferform (100) nach Anspruch 1, wobei mindestens ein Abschnitts des ersten vorläufigen Bereichs (125) und mindestens ein Abschnitt des zweiten vorläufigen Bereichs (135) einstückig miteinander sind.

4. Mehrzweck-Transferform (100) nach Anspruch 1, wobei ein Abschnitt des ersten vorläufigen Bereichs (125), der benachbart zu dem ersten Transferbereich (122) ist, eine konische Struktur mit einer Breite aufweist, die zu dem ersten Transferbereich hin abnimmt, und
wobei ein Abschnitt des zweiten vorläufigen Bereichs (135), der benachbart zu dem zweiten Transferbereich (132) ist, eine konische Struktur mit einer Breite aufweist, die zu dem zweiten Transferbereich hin abnimmt.

5. Mehrzweck-Transferform (100) nach Anspruch 1, wobei ein Abschnitt des ersten vorläufigen Bereichs (125), der benachbart zu dem ersten Transferbereich (122) ist, eine gerade geformte Struktur mit einer Breite aufweist, die gleich einer Breite des ersten Transferbereichs ist, und
wobei ein Abschnitt des zweiten vorläufigen Bereichs (135), der benachbart zu dem zweiten Transferbereich (132) ist, eine gerade geformte Struktur mit einer Breite aufweist, die gleich einer Breite des zweiten Transferbereichs ist.

6. Mehrzweck-Transferform (100) nach Anspruch 1, wobei ein erster Abschnitt des ersten vorläufigen Bereichs (125), der benachbart zu dem ersten Transferbereich (122) ist, eine gerade geformte Struktur mit einer Breite aufweist, die gleich einer Breite des ersten Transferbereichs ist,
wobei ein zweiter Abschnitt des ersten vorläufigen Bereichs, der benachbart zu dem ersten Abschnitt des ersten vorläufigen Bereichs ist, eine konische Struktur mit einer Breite aufweist, die zu dem ersten Abschnitt des ersten vorläufigen Bereichs hin abnimmt,
wobei ein erster Abschnitt des zweiten vorläufigen Bereichs (135), der benachbart zu dem zweiten Transferbereich (132) ist, eine gerade geformte Struktur mit einer Breite aufweist, die gleich einer Breite des zweiten Transferbereichs ist, und
wobei ein zweiter Abschnitt des zweiten vorläufigen Bereichs, der benachbart zu dem ersten Abschnitt des zweiten vorläufigen Bereichs ist, eine konische Struktur mit einer Breite aufweist, die zu dem ersten Abschnitt des zweiten vorläufigen Bereichs hin abnimmt.

7. Mehrzweck-Transferform (100) nach Anspruch 1, wobei jeder von dem ersten Transferbereich (122) und dem zweiten Transferbereich (132) eine Breite aufweist, die größer als eine Breite der mikrolichtemittierenden Transfereinrichtung (141) und kleiner als das Doppelte der Breite der mikrolichtemittierenden Transfereinrichtung ist.

8. Mehrzweck-Transferform (100) nach Anspruch 1, wobei jedes der Vielzahl von Pixeln (PX) eine Vielzahl von Subpixeln (SP1, SP2, SP3, SP4) beinhaltet und
wobei jeder von dem ersten Transferbereich (122) und dem zweiten Transferbereich (132) eine Größe aufweist, die einer Anzahl von mikrolichtemittierenden Transfereinrichtungen (141) entspricht, die in jedem der Vielzahl von Subpixeln beinhaltet ist.

9. Mehrzweck-Transferform (100) nach Anspruch 1, wobei der erste vorläufige Bereich (125) eine Breite aufweist, die gleich einer Breite des ersten Transferbereichs (122) oder größer als diese ist, und
wobei der zweite vorläufige Bereich (135) eine Breite aufweist, die gleich einer Breite des zweiten Transferbereichs (132) oder größer als diese ist.

10. Verfahren zur Herstellung einer Anzeigevorrichtung, wobei das Verfahren Folgendes umfasst:
Vorbereiten eines Transfersubstrats (110) einer Mehrzweck-Transferform (100), das eine Vielzahl von Pixeln (PX) umfasst, wobei jedes der Vielzahl von Pixeln eine erste Nut (120) und eine zweite Nut (130) umfasst, wobei die erste und zweite Nuten jeweils einen ersten und zweiten Transferbereich (122, 132) und einen ersten und zweiten vorläufigen Bereich (125, 135) umfassen, wobei der erste und zweite vorläufige Bereich jeweils einen ersten und zweiten Auslass (124, 134) umfassen, die dazu konfiguriert sind, zu ermöglichen, dass sich eine vorläufige mikrolichtemittierende Einrichtung (142) jeweils zu dem ersten und zweiten Transferbereich bewegt,
Zuführen von vorläufigen mikrolichtemittierenden Einrichtungen und Transfer von mikrolichtemittierenden Einrichtungen (141) zu jeder der ersten und zweiten Nut jedes der Vielzahl von Pixeln;
Ausrichten der mikrolichtemittierenden Transfereinrichtungen in den Transferbereichen und Ausrichten der vorläufigen mikrolichtemittierenden Einrichtungen in den vorläufigen Bereichen;
Klebetransferieren der mikrolichtemittierenden Transfereinrichtungen auf ein Pixel eines ersten Ansteuersubstrats (650), wobei das Pixel des ersten Ansteuersubstrats den mikrolichtemittierenden Transfereinrichtungen entspricht;
Bewegen der vorläufigen mikrolichtemittierenden Einrichtungen zu den Transferbereichen, die leer sind, nachdem die mikrolichtemittierenden Einrichtungen auf das Pixel des ersten Antriebssubstrats klebetransferiert wurden; und
Klebetransferieren der vorläufigen mikrolichtemittierenden Einrichtungen, die zu den Transferbereichen bewegt wurden, auf ein Pixel eines zweiten Ansteuersubstrats (660), wobei das Pixel des zweiten Ansteuersubstrats den vorläufigen mikrolichtemittierenden Einrichtungen entspricht.

11. Verfahren nach Anspruch 10, wobei jedes der Vielzahl von Pixeln (PX) eine Vielzahl von Subpixeln (SP1, SP2, SP3, SP4) beinhaltet, wobei die erste Nut und die zweite Nut in jeweiligen Subpixeln der Vielzahl von Subpixeln beinhaltet sind,
wobei der erste Transferbereich (122) der ersten Nut (120) zum Aufnehmen der mikrolichtemittierenden Transfereinrichtung (141) konfiguriert ist und der mit dem ersten Transferbereich verbundene erste vorläufigen Bereich (125) zum Aufnehmen der vorläufigen mikrolichtemittierenden Einrichtung (142) konfiguriert ist,
wobei der zweite Transferbereich (132) der zweiten Nut (130) zum Aufnehmen der mikrolichtemittierenden Transfereinrichtung (141) konfiguriert ist und der mit dem zweiten Transferbereich verbundene zweite vorläufigen Bereich (135) zum Aufnehmen der vorläufigen mikrolichtemittierenden Einrichtung konfiguriert ist.

12. Verfahren nach Anspruch 10 oder 11, wobei ein Abschnitt des ersten vorläufigen Bereichs (125), der benachbart zu dem ersten Transferbereich (122) ist, eine gerade geformte Struktur mit einer Breite aufweist, die gleich einer Breite des ersten Transferbereichs ist.

13. Verfahren nach Anspruch 10, 11 oder 12, wobei ein erster Abschnitt des ersten vorläufigen Bereichs (125), der benachbart zu dem ersten Transferbereich (122) ist, eine gerade geformte Struktur mit einer Breite aufweist, die gleich einer Breite des Transferbereichs ist, und wobei ein zweiter Abschnitt des ersten vorläufigen Bereichs, der benachbart zu dem Abschnitt des ersten vorläufigen Bereichs ist, eine konische Struktur mit einer Breite aufweist, die zu dem ersten Abschnitt des ersten vorläufigen Bereichs hin abnimmt.

14. Verfahren nach einem der Ansprüche 10 bis 13, wobei der erste Transferbereich (122) eine Breite aufweist, die größer als die Breite der mikrolichtemittierenden Transfereinrichtung (141) und kleiner als das Doppelte der Breite der mikrolichtemittierenden Transfereinrichtung ist.

15. Verfahren nach einem der Ansprüche 10 bis 14, wobei jedes der Vielzahl von Pixeln (PX) eine Vielzahl von Subpixeln (SP1, SP2, SP3, SP4) umfasst und
wobei der erste Transferbereich (122) eine Größe aufweist, die einer Anzahl von mikrolichtemittierenden Transfereinrichtungen (141) entspricht, die in jedem der Vielzahl von Subpixeln beinhaltet ist.

## Revendications

1. Moule de transfert à usages multiples (100) comprenant :
un substrat de transfert (110) comprenant une pluralité de pixels (PX), et une première rainure (120) et une seconde rainure (130) prévues dans chacun de la pluralité de pixels, ladite première rainure comprenant une première zone de transfert (122) configurée pour recevoir un microdispositif électroluminescent de transfert (141), et une première zone préliminaire (125) raccordée à la première zone de transfert et configurée pour recevoir un microdispositif électroluminescent préliminaire (142),
ladite première zone préliminaire comprenant une première sortie (124) configurée pour permettre au microdispositif électroluminescent préliminaire de se déplacer vers la première zone de transfert,
ladite seconde rainure comprenant une seconde zone de transfert (132) configurée pour recevoir le microdispositif électroluminescent de transfert, et une seconde zone préliminaire (135) raccordée à la seconde zone de transfert et configurée pour recevoir le microdispositif électroluminescent préliminaire, et
ladite seconde zone préliminaire comprenant une seconde sortie (134) configurée pour permettre au microdispositif électroluminescent préliminaire de se déplacer vers la seconde zone de transfert.

2. Moule de transfert à usages multiples (100) selon la revendication 1, ladite première zone de transfert (122) et ladite seconde zone de transfert (132) étant espacées l'une de l'autre.

3. Moule de transfert à usages multiples (100) selon la revendication 1, au moins une partie de la première zone préliminaire (125) et au moins une partie de la seconde zone préliminaire (135) étant solidaires l'une de l'autre.

4. Moule de transfert à usages multiples (100) selon la revendication 1, une partie de la première zone préliminaire (125), qui est adjacente à la première zone de transfert(122), comportant une structure conique comportant une largeur diminuant vers la première zone de transfert, et
une partie de la seconde zone préliminaire (135), qui est adjacente à la seconde zone de transfert (132), comportant une structure conique comportant une largeur diminuant vers la seconde zone de transfert.

5. Moule de transfert à usages multiples (100) selon la revendication 1, une partie de la première zone préliminaire (125), qui est adjacente à la première zone de transfert (122), comportant une structure de forme droite comportant une largeur qui est la même qu'une largeur de la première zone de transfert, et
une partie de la seconde zone préliminaire (135), qui est adjacente à la seconde zone de transfert (132), comportant une structure de forme droite comportant une largeur qui est la même qu'une largeur de la seconde zone de transfert.

6. Moule de transfert à usages multiples (100) selon la revendication 1, une première partie de la première zone préliminaire (125), qui est adjacente à la première zone de transfert (122), comportant une structure de forme droite comportant une largeur qui est la même qu'une largeur de la première zone de transfert,
une seconde partie de la première zone préliminaire, qui est adjacente à la première partie de la première zone préliminaire, comportant une structure conique comportant une largeur diminuant vers la première partie de la première zone préliminaire,
une première partie de la seconde zone préliminaire (135), qui est adjacente à la seconde zone de transfert (132), comportant une structure de forme droite comportant une largeur qui est la même qu'une largeur de la seconde zone de transfert, et
une seconde partie de la seconde zone préliminaire, qui est adjacente à la première partie de la seconde zone préliminaire, comportant une structure conique comportant une largeur diminuant vers la première partie de la seconde zone préliminaire.

7. Moule de transfert à usages multiples (100) selon la revendication 1, chacune de la première zone de transfert (122) et de la seconde zone de transfert (132) comportant une largeur qui est supérieure à une largeur du microdispositif électroluminescent de transfert (141) et inférieure à deux fois la largeur du microdispositif électroluminescent de transfert.

8. Moule de transfert à usages multiples (100) selon la revendication 1, chacun de la pluralité de pixels (PX) comprenant une pluralité de sous-pixels (SP1, SP2, SP3, SP4), et
chacune de la première zone de transfert (122) et de la seconde zone de transfert (132) comportant une taille correspondant à un nombre de microdispositifs électroluminescents de transfert (141) compris dans chacun de la pluralité de sous-pixels.

9. Moule de transfert à usages multiples (100) selon la revendication 1, ladite première zone préliminaire (125) comportant une largeur qui est supérieure ou égale à une largeur de la première zone de transfert (122), et
ladite seconde zone préliminaire (135) comportant une largeur qui est supérieure ou égale à une largeur de la seconde zone de transfert (132).

10. Procédé de fabrication d'un appareil d'affichage, le procédé comprenant :
la préparation d'un substrat de transfert (110) d'un moule de transfert à usages multiples (100) comprenant une pluralité de pixels (PX), chacun de la pluralité de pixels comprenant une première rainure (120) et une seconde rainure (130), lesdites première et seconde rainures comprenant une première et une seconde zone de transfert (122, 132) et une première et une seconde zone préliminaire (125, 135) respectivement, lesdites première et seconde zones préliminaires comprenant des première et seconde sorties (124, 134) respectivement configurées pour permettre à un microdispositif électroluminescent préliminaire (142) de se déplacer respectivement vers les première et seconde zones de transfert ;
la fourniture de microdispositifs électroluminescents préliminaires et de microdispositifs électroluminescents de transfert (141) à chacune des première et seconde rainures de chacun de la pluralité de pixels ;
l'alignement des microdispositifs électroluminescents de transfert sur les zones de transfert et l'alignement des microdispositifs électroluminescents préliminaires sur les zones préliminaires ;
le transfert par liaison des microdispositifs électroluminescents de transfert à un pixel d'un premier substrat de commande (650), le pixel du premier substrat de commande correspondant aux microdispositifs électroluminescents de transfert ;
le déplacement des microdispositifs électroluminescents préliminaires vers les zones de transfert, qui sont vides après que les microdispositifs électroluminescents de transfert ont été transférés par lien au pixel du premier substrat de commande ; et
le transfert par liaison des microdispositifs électroluminescents préliminaires déplacés vers les zones de transfert vers un pixel d'un second substrat de commande (660), le pixel du second substrat de commande correspondant aux microdispositifs électroluminescents préliminaires.

11. Procédé selon la revendication 10, chacun de la pluralité de pixels (PX) comprenant une pluralité de sous-pixels (SP1, SP2, SP3, SP4), ladite première rainure et ladite seconde rainure étant comprises dans des sous-pixels respectifs de la pluralité de sous-pixels,
ladite première zone de transfert (122) de la première rainure (120) étant configurée pour recevoir le microdispositif électroluminescent de transfert (141), et ladite première zone préliminaire (125) raccordée à la première zone de transfert étant configurée pour recevoir le microdispositif électroluminescent préliminaire (142),
ladite seconde zone de transfert (132) de la seconde rainure (130) étant configurée pour recevoir le microdispositif électroluminescent de transfert (141), et ladite seconde zone préliminaire (135) raccordée à la seconde zone de transfert étant configurée pour recevoir le microdispositif électroluminescent préliminaire.

12. Procédé selon la revendication 10 ou 11, une partie de la première zone préliminaire (125), qui est adjacente à la première zone de transfert (122), comportant une structure de forme droite comportant une largeur qui est la même qu'une largeur de la première zone de transfert.

13. Procédé selon la revendication 10, 11 ou 12, une première partie de la première zone préliminaire (125), qui est adjacente à la première zone de transfert (122), comportant une structure de forme droite comportant une largeur qui est la même qu'une largeur de la zone de transfert, et une seconde partie de la première zone préliminaire, qui est adjacente à la partie de la première zone préliminaire, comportant une structure conique comportant une largeur diminuant vers la première partie de la première zone préliminaire.

14. Procédé selon l'une quelconque des revendications 10 à 13, ladite première zone de transfert (122) comportant une largeur qui est supérieure à une largeur du microdispositif électroluminescent de transfert (141) et inférieure à deux fois la largeur du microdispositif électroluminescent de transfert.

15. Procédé selon l'une quelconque des revendications 10 à 14, chacun de la pluralité de pixels (PX) comprenant une pluralité de sous-pixels (SP1, SP2, SP3, SP4), et
ladite première zone de transfert (122) comportant une taille correspondant à un nombre de microdispositifs électroluminescents de transfert (141) compris dans chacun de la pluralité de sous-pixels.
